# EUROPÄISCHE PATENTSCHRIFT

(11) **EP 0 927 398 B1**
(45) Veröffentlichungstag und Bekanntmachung des Hinweises auf die Patenterteilung: **08.03.2000**
(21) Anmeldenummer: 97909147.7
(22) Anmeldetag: 18.09.1997
(51) Int. Cl.: G06F 17/50

(54) **VERFAHREN ZUR ERMITTLUNG VON OPTIMIERTEN KOPPLUNGEN VON KNOTEN IN EINEM VORGEGEBENEN GRAPH MÖGLICHER KOPPLUNGEN, WOBEI DER GRAPH EIN TECHNICHES SYSTEM DARSTELLT**
OPTIMIZATION OF NODE COUPLES IN A GIVEN GRAPH SHOWING COUPLING POSSIBILITIES, WHEREBY THE GRAPH REPRESENTS A TECHNICAL SYSTEM
TECHNIQUE D'OPTIMISATION DES COUPLES DE NOEUDS DANS UN GRAPHE DONNE DE COUPLAGES POSSIBLES, LE GRAPHE REPRESENTANT UN SYSTEME TECHNIQUE

(30) Priorität: 18.09.1996 DE 19638132
(43) Veröffentlichungstag der Anmeldung: 07.07.1999
(73) Patentinhaber: SIEMENS AKTIENGESELLSCHAFT, 80333 München (DE)
(72) Erfinder: LAUTHER, Ulrich, D-80686 München (DE); MALISCH, Frank-Oliver, D-85579 Neubiberg (DE)
(86) Internationale Anmeldenummer: DE9702108
(87) Internationale Veröffentlichungsnummer: WO9812652

(56) Entgegenhaltungen:
- ROSENWEIN ET AL: "a constrained steiner tree problem" EUROPEAN JOURNAL OF OPERATIONAL RESEARCH, Bd. 81, Nr. 2, März 1995, NETHERLANDS, Seiten 430-439, XP002057847
- NOVAK R ET AL: "DISTRIBUTION OF CONSTRAINED STEINER TREE COMPUTATION IN SHORTEST-DELAY NETWORKS" MELECON '96. 8TH. MEDITERRANEAN ELECTROTECHNICAL CONFERENCE INDUSTRIAL APPLICATIONS IN POWER SYSTEMS, COMPUTER SCIENCE AND TELECOMMUNICATIONS, BARI, IT., MAY 13 - 16, 1996, Bd. VOL. 2, Nr. CONF. 8, 13.Mai 1996, DE SARIO M;MALONE B; PUGLIESE P; SAVINO M (EDS ), Seiten 959-962, XP000699429
- CONG J ET AL: "PROVABLY GOOD ALGORITHMS FOR PERFORMANCE-DRIVEN GLOBAL ROUTING" PROCEEDINGS OF THE INTERNATIONAL SYMPOSIUM ON CIRCUITS AND SYSTEMS, SAN DIEGO, MAY 10 - 13, 1992, Bd. 5 OF 6, 10.Mai 1992, INSTITUTE OF ELECTRICAL AND ELECTRONICS ENGINEERS, Seiten 2240-2243, XP000338436
- DONGSHENG ET AL: "performance-driven interconnect global routing" IEEE PROCEEDINGS OF THE SIXTH GREAT LAKES SYMPOSIUM ON VLSI, 22. - 23.März 1996, US, Seiten 132-136, XP002057848

## Beschreibung

Verfahren zur Ermittlung von optimierten Kopplungen von Knoten in einem vorgegeben Graph möglicher Kopplungen, durch einen Rechner, wobei die Graph die Struktur eines technischen Systems beschreibt.

### 1 . Technischer Hintergrund

Es ist ein bekanntes Problem, in einem vorgegebenen Graph, der eine beliebige Anzahl von Knoten und Kanten aufweist, möglichst optimierte Kopplungen zwischen den Knoten zu ermitteln. Optimiert bedeutet in diesem Zusammenhang beispielsweise bei der Zuordnung von Kosten zu den Kanten des Graphen, daß eine Teilmenge von Kanten ausgewählt wird, die im weiteren als Baum bezeichnet werden, so daß gewisse, vorgegebene Knoten des Graphen verbunden sind und die Gesamtkosten der ausgewählten Kanten minimal wird. Dieses Problem wird als Steiner-Baum-Problem bezeichnet.

Das Steiner-Baum-Problem tritt in verschiedensten technischen Gebieten auf, beispielsweise bei der Planung und Verlegung von Kommunikationsnetzen, die beispielsweise eine Baumstruktur aufweisen, oder auch bei dem Layout-Design elektrischer Netzwerke, z. B. bei einem VLSI-Layout-Design.

### 2. Stand der Technik

Zur Lösung des Steiner-Baum-Problems existieren verschiedenste bekannte Heuristiken, die üblicherweise auf der sequenziellen Ermittlung kostenkürzester Pfade beruhen. Eine Übersicht über einige Verfahren, mit denen das Steiner-Baum-Problem gelöst wird, ist in dem Dokument [1] zu finden.

Grundlagen über das Steiner-Baum-Problem und die Einsatzmöglichkeiten beispielsweise zum Layout-Design elektrischer Netzwerkgraphen sind in den Dokumenten [2] und [3] beschrieben.

Aus dem Dokument [4] sind sog. Ripup/Reroute-Verfahren bekannt.

Bei den aus dem Dokument [1] bekannten Verfahren zur Ermittlung der kostenkürzesten Pfade und somit der Lösung des Steiner-Baum-Problems werden den einzelnen Knoten des Graphen sog. Knotenlabel zugeordnet. Mit den Knotenlabeln wird jeweils während des Verfahrens die vorläufige Distanz des jeweiligen Knotens zu einem Wurzelknoten des Graphen bezeichnet. Somit werden mit den Knotenlabeln die während des sequenziellen Verfahrens vorläufigen Kosten des jeweils aktuell optimierten Pfades, der Verbindung des Wurzelknotens zu dem jeweiligen Knoten des Graphen beschrieben.

Während des Verfahrens werden die Werte der Knotenlabel üblicherweise erniedrigt, wenn der jeweilige Knoten von einem Nachbarknoten aus auf einem kürzeren Pfad als bisher bekannt erreicht werden kann.

Durch diese Verfahren werden die Kosten der Kopplungen zwischen den Knoten optimiert.

Diese Verfahren weisen jedoch den Nachteil auf, daß Probleme, bei denen zusätzlich zu dem Optimierungsproblem, d. h. dem Steiner-Baum-Problem, vorgegebene Restriktionen berücksichtigt werden müssen.

Eine solche Restriktion kann beispielsweise in einer Längenrestriktion von Kopplungen oder auch in einer Restriktion von Laufzeiten elektrischer Signale beispielsweise in einem elektrischen Netzwerkgraphen, zu sehen sein.

Die folgenden drei Dokumente:
1) NOVAK R ET AL: "DISTRIBUTION OF CONSTRAINED STEINER TREE COMPUTATION IN SHORTEST-DELAY NETWORKS" MELECON '96. 8TH. MEDITERRANEAN ELECTROTECHNICAL CONFERENCE INDUSTRIAL APPLICATIONS IN POWER SYSTEMS, COMPUTER SCIENCE AND TELECOMMUNICATIONS, BARI, IT., MAyl3 - 16, 1996, Bd. VOL. 2, Nr. CONF. 8, 13.Mai 1996, DE SARIO M;MALONE B; PUGLIESE P; SAVINO M (EDS ), Seiten 959-962.
2) ROSENWEIN ET AL: "a constrained steiner tree problem" EUROPEAN JOURNAL OF OPERATIONAL RESEARCH, Bd. 81, Nr. 2, März 1995, NETHERLANDS, Seiten 430-439.
3) CONG J ET AL: "PROVABLY GOOD ALGORITHMS FOR PERFORMANCE-DRIVEN GLOBAL ROUTING" PROCEEDINGS OF THE INTERNATIONAL SYMPOSIUM ON CIRCUITS AND SYSTEMS, SAN DIEGO, MAyl0 - 13, 1992, Bd. 5 OF 6, 10.Mai 1992, INSTITUTE OF ELECTRICAL AND ELECTRONICS ENGINEERS, Seiten 2240-2243.
zeigen Verfahren zur rechnergestützten Ermittlung von optimierten Kopplungen von Knoten in einem vorgegebenen Graph möglicher Kopplungen, wobei zur Ermitlung dieser optimierten Kopplungen ein Steiner-Baum-Problem gelöst wird und bei der Lösung des Steiner-Baum-Problems eine Restriktion (Delay) berücksichtigt werden kann.

Das zuerst genannnte Dokument (Novak et al.) zeigt zusätzlich, daß mindestens einem Teil der Knoten des Graphen Knotenlabel zugeordnet sind; und daß mindestens einem Teil der Kanten des Graphen Kosten C(e) zugeordnet werden, wobei Knotenlabel und Kosten in jeweils getrennten Funktionen definiert werden.

Somit liegt der Erfindung das Problem zugrunde, ein Verfahren zur Ermittlung von optimierten Kopplungen von Knoten in einem vorgegebenen Graphen möglicher Kopplungen anzugeben, bei dem ein Steiner-Baum-Problem unter Berücksichtigung von Restriktionen gelöst werden kann.

Das Problem wird durch das Verfahren gem. Patentanspruch 1 gelöst.

### 3. Kurzbeschreibung der Erfindung

Mit dem Verfahren wird erstmals ein Steiner-Baum-Problem gelöst, wobei eine vorgebbare Anzahl von z. B. Pfadlängen-Restriktionen während der Lösung des Steiner-Baum-Problems berücksichtigt werden kann.

Vorteilhafte Weiterbildungen der Erfindung ergeben sich aus den abhängigen Ansprüchen.

Eine Möglichkeit zur Berücksichtigung der Restriktionen während der Lösung des Steiner-Baum-Problems liegt beispielsweise darin, den Knoten anstelle der üblichen Knotenlabel mehrdimensionale Knotenlabelfunktionen zuzuweisen, die die während des Verfahrens vorläufigen Kosten als Funktion der Restriktion beschreiben.

Ferner wird der in den bekannten Verfahren auftretende Verfahrensschritt der Erniedrigung eines Knotenlabels ersetzt durch jeweils eine geeignete Kombination der Knotenlabelfunktionen der beteiligten Knoten in dem jeweiligen Optimierungsschritt.

Durch die Verwendung von mehrdimensionalen Knotenlabelfunktionen, die beispielsweise eine Funktion der Kosten abhängig von den jeweiligen Restriktionen darstellt, wird die explizite Berücksichtigung von Restriktionen während der Lösung des Steiner-Baum-Problems möglich.

In einer Weiterbildung des Verfahrens ist es vorteilhaft, die Kombination der Knotenlabelfunktionen in einer Weise durchzuführen, daß bezüglich der Kosten und der Restriktion der Knotenlabelfunktionen eine Optimal-Einhüllende gebildet wird, die dem jeweiligen Knoten als neue Knotenlabelfunktion zugeordnet wird. Durch diese Vorgehensweise wird das Ergebnis des Verfahrens weiter verbessert.

Ferner ist es in einer Weiterbildung des Verfahrens vorteilhaft, diejenigen Punkte einer Knotenlabelfunktion bei dem mindestens eine Restriktion verletzt wird, im weiteren Verfahren nicht mehr zu berücksichtigen. Durch diese Weiterbildung wird eine erhebliche zusätzliche Rechenzeiteinsparung bei der Durchführung des Verfahrens durch einen Rechner erreicht.

Eine weitere Verbesserung der erzielten Ergebnisse wird dadurch erreicht, daß in einer Weiterbildung des Verfahrens ein sog. Ripup/Reroute-Verfahren auf den sich ergebenden optimierten Graphen angewendet wird.

In einer Weiterbildung der Ripup/Reroute-Verfahren ist es vorteilhaft, daß bei der Ermittlung einer neuen Ripup-Verbindung lediglich in einer lokalen Umgebung vorgebbare Größe des Ripup-Knotens gesucht wird.

Durch diese Einschränkung des Suchbereichs der zu ermittelnden Ripup-Verbindungen wird eine weitere Einsparung benötigter Rechenzeit zur Durchführung des Verfahrens erreicht.

Das Verfahren kann vorteilhaft beispielsweise zur Planung und/oder Verlegung von Kommunikationsnetzen, die z. B. eine Baumstruktur aufweisen, oder zum Layout-Design elektrischer Netzwerkgraphen verwendet werden.

### 4. Kurze Figurenbeschreibung

In den Figuren ist ein Ausführungsbeispiel der Erfindung dargestellt, welches im weiteren näher erläutert wird.

Es zeigen
- Fig. 1: ein Graph eines einfachen Ausführungsbeispiels mit sieben Knoten und Kanten, denen jeweils Kosten zugeordnet sind;
- Fig. 2: eine Matrix, mit der ein bekanntes sog. Labeling and Scanning Verfahren beschrieben wird;
- Fig. 3a bis 3f: mögliche Knotenlabelfunktionen, die zu Beginn des Verfahrens den einzelnen Knoten zugewiesen werden können;
- Fig. 4: ein Ablaufdiagramm, in dem die einzelnen Verfahrensschritte des Verfahrens mit einigen Weiterbildungen des Verfahrens dargestellt ist;
- Fig. 5: eine Rechneranordnung, mit der das Verfahren durchgeführt werden kann.

### 5. Figurenbeschreibung

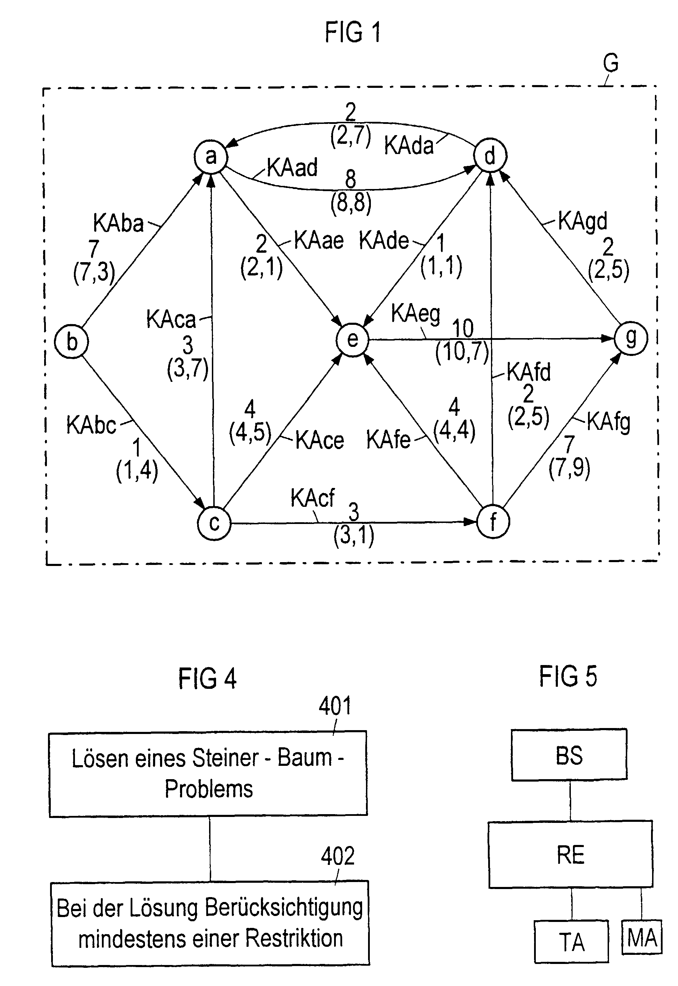

In Fig. 1 ist ein Graph G mit in diesem einfachen Ausführungsbeispiel 8 Knoten KNi und Kanten KNjl dargestellt.

Mit einem ersten Index i wird jeder Knoten KNi eindeutig gekennzeichnet. In Fig. 1 sind die einzelnen Knoten mit den Buchstaben a, b, c, d, e, f, g bezeichnet. Der Index i ist allgemein eine beliebige natürliche Zahl zwischen 1 und n, wobei mit n die Anzahl der Knoten KNi in dem Graphen G bezeichnet wird. Mit den Indizes jl wird für jede Kante KAjl jeweils mit dem Index j der Knoten KNi bezeichnet, von dem die Kante bei einem gerichteten Graphen G ausgeht und mit 1 wird ein Endknoten der Kante KAjl bezeichnet. Die Indizes j und 1 sind ebenso natürliche Zahlen, ebenfalls im Bereich von 1 bis n.

In diesem zur einfacheren Darstellung sehr einfach gehaltenen Graphen G besteht nun die Aufgabe, eine Menge von Pfaden von einem frei vorgebbaren Wurzelknoten innerhalb des vorgegebenen Graphen G zu ermitteln, so daß die Gesamtkosten aller verwendeten Kanten minimal wird.

Dieses Problem wird allgemein als Steiner-Baum-Problem bezeichnet.

Zur Lösung dieses Steiner-Baum-Problems sind verschiedenste Heuristiken beispielsweise zur Bestimmung kürzester Pfade bekannt, z. B. aus dem Dokument [1].

Auch wenn im weiteren lediglich zur einfacheren Darstellung das Verfahren zur Bestimmung kürzester Pfade nach Dijkstra beschrieben wird, so sind jedoch alle anderen Verfahren zur Lösung des Steiner-Baum-Problems in dem Verfahren verwendbar, bei denen während des Verfahrens den einzelnen Knoten KNi Knotenlabel zugeordnet werden.

Bei den bekannten Labeling and Scanning Verfahren wird ausgehend von einem Wurzelknoten, bei dem in Fig. 1 dargestellten Beispiel der Knoten mit der Bezeichnung b eine Pfadmatrix PM iterativ auf folgende Weise erstellt. Unter einem Labeling and Scanning Verfahren sind in diesem Zusammenhang Verfahren zu verstehen, die z. B. in dem Dokument [5] beschrieben sind, beispielsweise das sog. Pape-Moore-Verfahren.

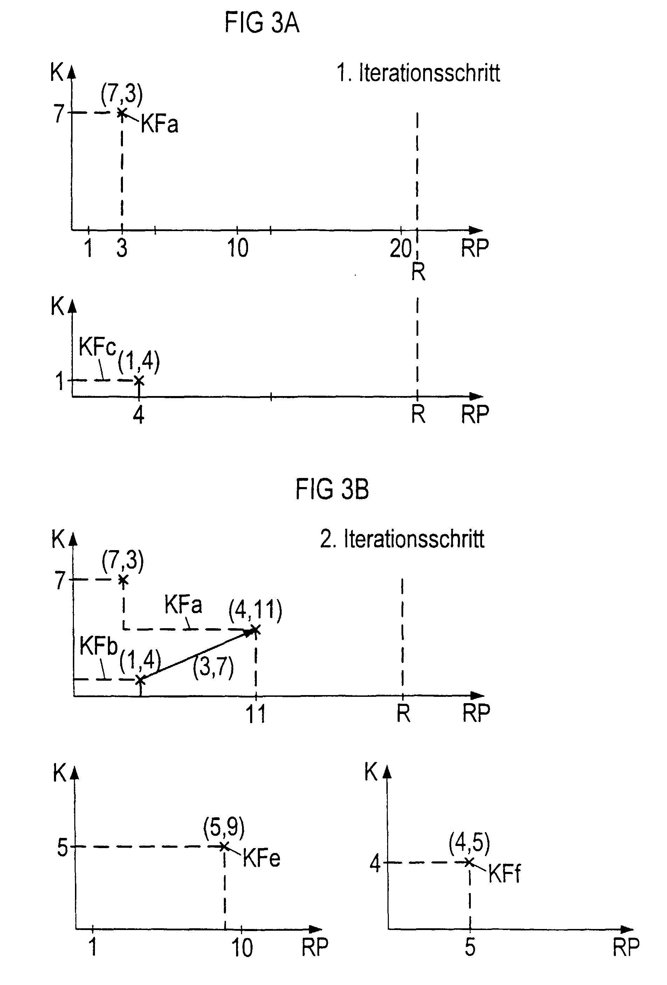

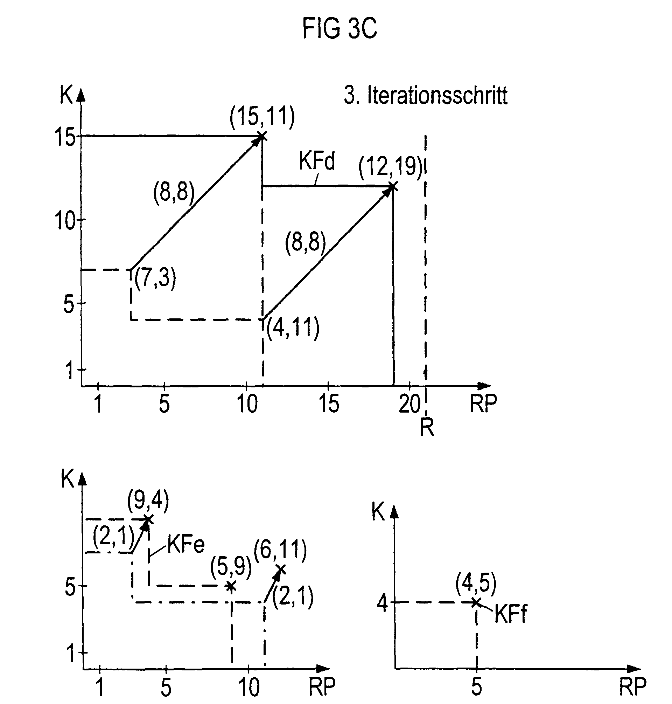

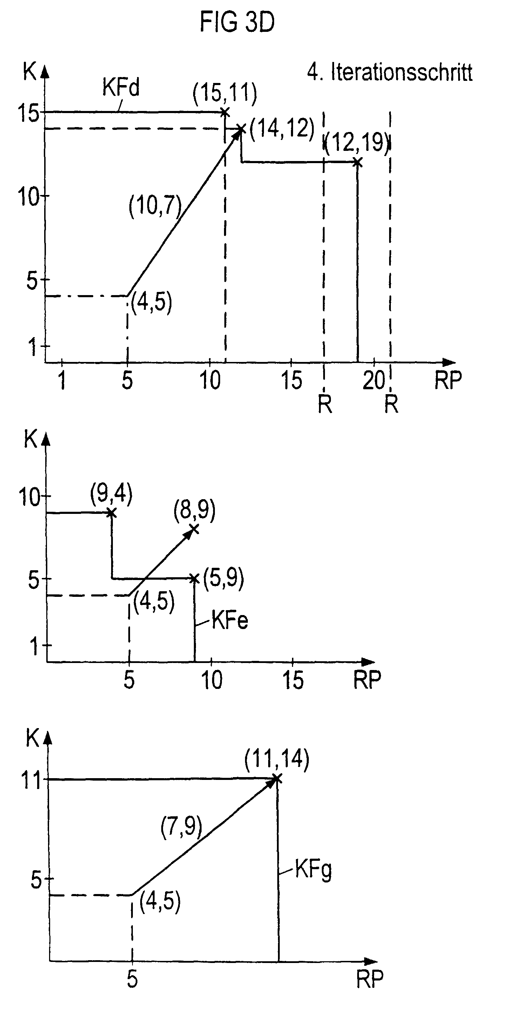

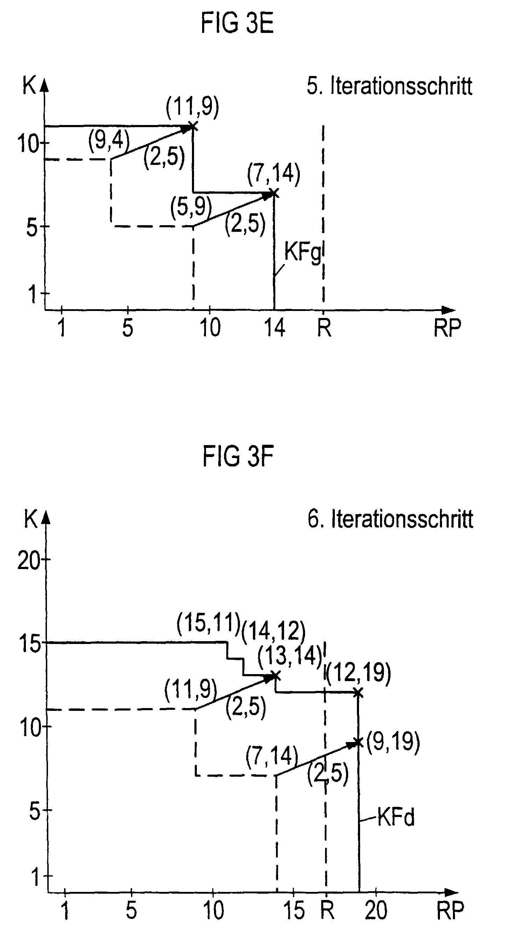

Die Pfadmatrix PM ist in Fig. 3 dargestellt. Sie enthält beispielsweise folgende Spalten:
- Eine Angabe des jeweiligen Iterationsschrittes m,
- eine Angabe z des jeweils in dem Verfahrensschritt iterativ neu hinzugenommenen Knoten KNjl, zu dem der kürzeste Pfad in diesem Iterationsschritt ermittelt wurde,
- für alle Knoten außer dem Wurzelknoten, zu dem jeweils ein kürzester Pfad ermittelt werden soll, eine Spalte, in der jeweils zu dem aktuellen Iterationsschritt die Kosten für den zu dem Iterationsschritt aktuell kostengünstigsten Pfad ausgehend von dem Wurzelknoten zu dem jeweiligen Knoten KNi angegeben wird.

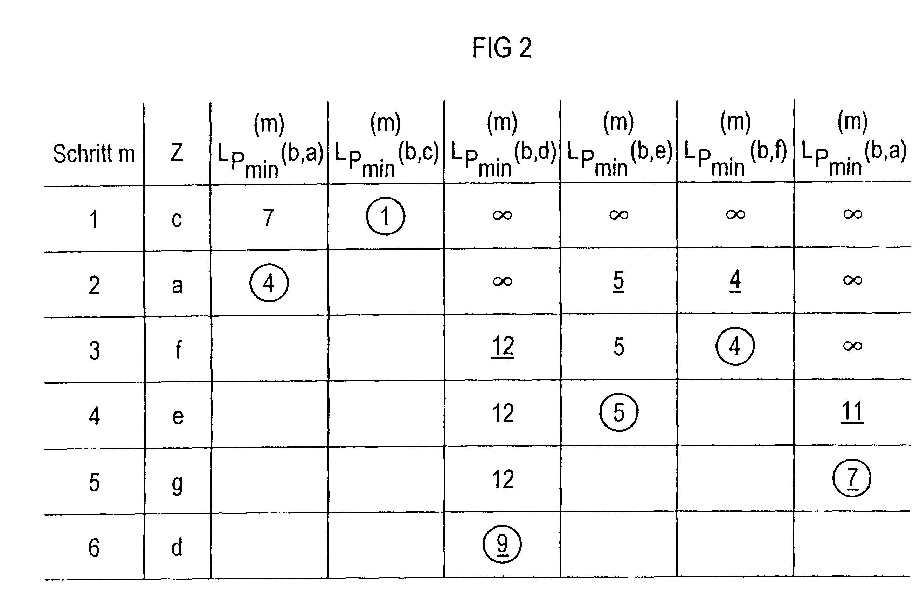

In Fig. 2 ist jeweils der in dem Iterationsschritt als Lösung des kürzesten Pfadalgorithmus ausgewählter Knoten durch einen Kreis um das jeweilige Kostenlabel symbolisiert.

Durch das Symbol ∞ wird gekennzeichnet, daß der jeweilige Knoten zu diesem Iterationsschritt noch nicht erreichbar ist, ausgehend von dem Wurzelknoten über die Kanten KAjl des Graphen G.

Die Werte, die jeweils zu dem Iterationsschritt in einer Spalte der Pfadmatrix PM dargestellt sind, werden als Knotenlabel bezeichnet. Mit einem Knotenlabel wird jeweils eine Summe der vorläufigen Kosten bezeichnet, die sich ergeben, wenn der Knoten KNi ausgehend von dem Wurzelknoten über den bisher günstigsten Pfad erreicht wird.

Bei den bekannten Verfahren zur Ermittlung kürzester Pfade ist das Knotenlabel jeweils durch einen Wert gegeben, der die Kosten zur Erreichung des Knoten KNi ausgehend von dem Wurzelknoten beschreibt.

Bei den bekannten Labeling and Scanning Verfahren wird in jedem Verfahrensschritt in der jeweiligen Zeile des Verfahrensschrittes ein noch nicht gescannter aber gelabelter Knoten KN ausgewählt. Zu dem ausgewählten Knoten ist in diesem Verfahrensschritt ein vorläufiger Pfad in dem Graphen G ermittelt worden. Die Kosten dieses Pfades entsprechen dem Wert des Knotenlabels zu dem jeweiligen Iterationsschritt. Durch Hinzunahme des jeweiligen Knotens KNi in einen Teilgraph, der iterativ in den einzelnen Iterationsschritten aufgebaut wird, ausgehend von dem Wurzelknoten, werden für den nächsten Iterationsschritt neue mögliche Pfade generiert, und der Wert eines Knotenlabels wird dann verändert, wenn ein neuer Pfad kostengünstiger ist als die Kosten des bisherigen Pfades, repräsentiert durch das jeweilige Knotenlabel des letzten Iterationsschrittes.

Nachdem in einem ersten Verfahrensschritt ausgehend von dem Wurzelknoten b des Graphen G die Knoten a und c erreichbar sind (vgl. Fig. 1), werden in dem ersten Iterationsschritt den Knoten a das Knotenlabel mit dem Wert 7 und dem Knoten c das Knotenlabel mit dem Wert 1 zugeordnet. Alle anderen Knoten KNi sind nach dem ersten Iterationsschritt noch nicht erreichbar.

Der Knoten c ist kostengünstiger erreichbar als der Knoten a, da das Knotenlabel des Knotens c kleiner ist als der Wert des Knotenlabels des Knoten a. Somit wird der Knoten c in den Teilgraphen mitaufgenommen und alle möglichen inzidenten Kanten KAjl des Graphen G werden in dem zweiten Iterationsschritt untersucht. Der Wert des Knotenlabels eines Knotens wird dann erniedrigt, wenn sich ein neuer Pfad von dem Wurzelknoten b zu dem Knoten KNjl ergibt, der kostengünstiger ist als der bisherige kostengünstigste Pfad.

Für den Knoten a ist dies der Fall, da dieser nunmehr über die Kanten KAbc und KAca mit Summenkosten 4 günstiger erreichbar ist als über die Kante KAba mit den Summenkosten 7.

Somit wird dem Knotenlabel des Knotens a der neue Wert 4 zugeordnet. Ferner sind die Knoten e und die Knoten f in diesem Beispiel nunmehr neu erreichbar, mit den Summenkosten 5 und 4. Diese iterative Verfahren wird solange durchgeführt, bis alle Knoten KNi, die miteinander gekoppelt werden sollen, über den jeweiligen kostengünstigsten Pfad miteinander verbunden werden können.

Bei dem erfindungsgemäßen Verfahren wird nunmehr anstelle des Knotenlabels eine Knotenlabelfunktion KF verwendet, die jeweils mindestens einem Teil der Knoten KNi des Graphen G zugeordnet werden.

Die Knotenlabelfunktion KF beschreibt jeweils eine mehrdimensionale Funktion der Kosten abhängig von mindestens einem Restriktionsparameter RP. Unter einem Restriktionsparameter RP sind im weiteren diejenigen Parameter zu verstehen, für die eine Restriktion vorgegeben ist, die in dem Verfahren zur Lösung des Steiner-Baum-Problems berücksichtigt werden soll.

Beispielsweise kann ein solcher Restriktionsparameter RP in einer zulässigen maximalen Pfadlänge oder auch in Laufzeiten von elektrischen Signalen, wie im weiteren beschrieben wird, zu sehen sein.

Auch wenn die Anzahl von Restriktionen, die in dem Verfahren berücksichtigt werden können und somit die Dimensionalität der Knotenlabelfunktion KF allgemein beliebig ist, so wird im weiteren zur einfacheren Darstellbarkeit des Verfahrens lediglich der Fall einer Restriktion R und eines Restriktionsparameters RP dargestellt.

Die einzelnen Knotenlabelfunktionen KF zu den Iterationsschritten sind in den Fig. 3a bis 3f dargestellt. Bei dem Verfahren ist jeder Kante KAjl zusätzlich zu dem Kostenwert noch ein Wert des jeweiligen Restriktionsparameters RP, der durch Aufnahme der Kante in den Pfad zu dem jeweiligen Knoten verursacht wird, enthalten. Dies ist in einem Wertetupel in Fig. 1 dargestellt. Mit dem ersten Tupels ist der Kostenwert für die jeweilige Kante KAjl angegeben und mit dem zweiten Wert des Tupels der Wert des jeweiligen Restriktionsprameters RP.

Zu Beginn des Verfahrens, d. h. in dem ersten Iterationsschritt werden alle Knotenlabelfunktionen KF beispielsweise mit dem Wert 0 initialisiert.

In einem ersten Schritt wird der Wurzelknoten b innerhalb des Graphen G gewählt, in diesem einfachen Beispielsfall ist dies der Knoten b. Ausgehend von dem Wurzelknoten b können in dem Graphen G die Knoten a und c über jeweils eine gerichtete Kante KAbc bzw. KAba erreicht werden.

Der Kante KAba ist das Kosten-Restriktions-Tupel (7, 3) und der Kante KAbc das Kosten-Restriktions-Tupel (1, 4) zugeordnet.

Es ergibt sich folgende zweidimensionale, für den allgemeinen Fall einer beliebigen Anzahl von Restriktionen und somit berücksichtigter Restriktionsparameter RP mehrdimensionale Knotenlabelfunktion KFa für den Knoten a und die Knotenlabelfunktion KFc für den Knoten c in dem ersten Verfahrensschritt, die in Fig. 3a dargestellt sind.

Als Restriktion R wird in diesem Beispielsfall ein Restriktionsparameter RP mit dem Wert 17 angenommen.

In dem ersten Iterationsschritt enthält die Knotenlabelfunktion KFa für den Knoten a einen Punkt, das Kosten-Restriktions-Tupel (7, 3). Die Knotenlabelfunktion KFc für den Knoten c weist ebenso lediglich einen Punkt auf, das Knoten-Restriktions-Tupel (1, 4).

Als Knoten, zu dem der optimierte Pfad gewählt wird, wird in dem ersten Iterationsschritt der Knoten c gewählt, da der Knoten c zu geringeren Kosten von dem Wurzelknoten b aus erreichbar ist als der Knoten a.

Durch Hinzunahme des Knotens c ergibt sich ein weiterer Teilgraph, in dem die Kanten KAca, KAce und KAcf neu in dem Verfahren berücksichtigt werden.

Für den zweiten Iterationsschritt ergeben sich die in Fig. 3b dargestellten Knotenlabelfunktionen KFa, KFe und KFf für die Knoten a, e, f.

Die neue Knotenlabelfunktion KFa des Knotens a ergibt sich nun durch Kombination der Knotenlabelfunktionen KFa und KFb, da nunmehr der Knoten a auch über den Knoten c und die Kante KAca erreichbar ist. Die Kombination der Knotenlabelfunktionen KFa und KFb zu einer neuen Knotenlabelfunktion KFa in dem zweiten Iterationsschritt erfolgt vorteilhafterweise in der Weise, daß die Knotenlabelfunktion KFc, verschoben um das Kosten-Restriktions-Tupel (3, 7) der Kante KAca mit der Knotenlabelfunktion KFa des Knotens a in dem ersten Iterationsschritt kombiniert wird.

Die Knotenlabelfunktionen KFe und KFf weisen jeweils lediglich einen Punkt auf, der sich ergibt aus der Summe der Komponenten der Kosten-Restriktions-Tupel der Kanten, die jeweils zu dem Knoten e bzw. f führen.

Als nächster Knoten, zu dem der kostenoptimierte Pfad bestimmt wird, wird der Knoten a gewählt, da dieser die minimale Kosten in dem Gesamtpfad von dem Wurzelknoten b zu dem jeweiligen Knoten aufweist.

Durch Aufnahme des Knotens a in den Teilgraph des dritten Iterationsschrittes werden drei neue Kanten und ein neuer Knoten berücksichtigt, nämlich zwei Kanten KAad KAae sowie der Knoten d.

Es ergeben sich wiederum durch Kombination von Knotenlabelfunktionen KF die in Fig. 3c dargestellten Knotenlabelfunktionen KFd, KFe, KFf für die Knoten d, e, f in dem dritten Iterationsschritt. Die Knotenlabelfunktion KFd des Knotens d weist in dem dritten Iterationsschritt einen Punkt auf, welcher durch Summenbildung der Kosten-Restriktions-Tupel (7, 3) und (8, 8) entsteht.

Der Punkt der Knotenlabelfunktion KFd des Knotens d ist gegeben durch (15, 11).

Der Knoten e ist nunmehr über drei Pfade erreichbar, über die Kanten KAba und KAae, über die Kanten KAbc, KAca und KAae sowie die Kanten KAbc und KAce. Somit ergeben sich drei Kosten-Restriktions-Tupel für jeden Pfad, die die Knotenlabelfunktion KFe für den Knoten e ergeben.

Vereinfacht dargestellt ergibt sich die Knotenlabelfunktion KFe durch Kombination der Knotenlabelfunktion KFa des Knotens a aus dem zweiten Iterationsschritt mit der Knotenlabelfunktion KFe des Knotens e zum zweiten Iterationsschritt, wobei die Knotenlabelfunktion KFa des Knotens a zu dem zweiten Iterationsschritt, verschoben um das Kosten-Restriktions-Tupel (2, 1), welches der Kante KAae zugeordnet ist, bei der Kombination verwendet wird.

Wie aus Fig. 4c schon ersichtlich ist, ergibt das Tupel (6, 11) höhere Kosten für einen höheren Wert des Restriktionsparameters RP. Für den Fall, daß in der Weiterbildung des Verfahrens vorgesehen ist, daß als Ziel der Optimierung eine möglichst kostenoptimale Realisierung bei möglichst kleinen Werten des Restriktionsparameters RP erfolgt, brauch bei dieser Weiterbildung der Punkt (6, 11) in der Knotenlabelfunktion KFe in dem dritten Iterationsschritt schon nicht mehr berücksichtigt werden, so daß für diese Weiterbildung die Knotenlabelfunktion KFe in dem dritten Iterationsschritt lediglich die Punkte (9, 4) und (5, 9) enthält.

Die Knotenlabelfunktion KFf des Knotens f enthält weiterhin nur den Punkt (4, 5) da durch Hinzunahme des Knotens a in den Teilgraphen des Verfahrens in dem zweiten Iterationsschritt kein neuer Pfad hinzugekommen ist, über den der Knoten f erreicht werden kann.

In Fig. 3d sind die Knotenlabelfunktionen KF des vierten Iterationsschrittes nach Aufnahme des Knotens f in den Teilgraphen des dritten Iterationsschrittes dargestellt. Durch Hinzunahme des Knotens f wird nun erstmals auch der Knoten g, ausgehend von dem Wurzelknoten b, erreichbar. Ferner sind drei neue Kanten KAfe, KAfd und KAfg als potentielle neue Pfade zu den Knoten e, d sowie g zu berücksichtigen. Wiederum ergibt sich die Knotenlabelfunktion KFd des Knotens d in dem vierten Iterationsschritt durch Kombination der Knotenlabelfunktion KFf des dritten Iterationsschrittes, verschoben um das Kosten-Restriktions-Tupel (10, 7) mit der unverschobenen Knotenlabelfunktion KFd des dritten Iterationsschrittes.

Es ist in einer Weiterbildung vorteilhaft, bei der Kombination jeweils die "untere Einhüllende" beider Knotenlabelfunktionen, die miteinander kombiniert werden, zu wählen. Durch diese Weiterbildung wird erhebliche Rechenzeit bei der Durchführung des Verfahrens eingespart.

Die Knotenlabelfunktion KFe des Knotens e im vierten Iterationsschritt ergibt sich wiederum durch Kombination der Knotenlabelfunktion KFe und KFf des dritten Iterationsschrittes. Für die Weiterbildung, daß lediglich die "untere Einhüllende" als Optimal-Einhüllende der jeweils aktuellen Knotenlabelfunktion KF verwendet wird, wird der sich durch Verschiebung der Knotenlabelfunktion KFf des dritten Iterationsschrittes ergebende Punkt (8, 9) nicht mehr berücksichtigt.

Die Knotenlabelfunktion KFe des Knotens e in dem vierten Iterationsschritts bleibt somit gegenüber der Knotenlabelfunktion KFe des dritten Iterationsschrittes unverändert.

Die neue Knotenlabelfunktion KFg des Knotens g des vierten Iterationsschrittes ergibt sich durch zweidimensionale Verschiebung um das Kosten-Restriktions-Tupel (7, 9), ausgehend von der Knotenlabelfunktion KFf des dritten Iterationsschrittes. Die Restriktion R mit dem Wert 15 wird bei der Knotenlabelfunktion KFd des Knotens d in dem Punkt (12, 19) sowohl im dritten Iterationsschritt als auch in dem vierten Iterationsschritt nicht mehr eingehalten. Somit kann dieser Punkt bei der weiteren Betrachtung weggelassen werden, was in einer Weiterbildung des Verfahrens auch vorgesehen ist.

In dem vierten Iterationsschritt wird der Knoten e ausgewählt, wodurch die neue Kante KAeg mit dem Kosten-Restriktions-Tupel (2, 5) neu in dem Verfahren berücksichtigt wird. Dies führt zu einer neuen Knotenlabelfunktion KFg für den Knoten g in dem fünften Iterationsschritt (vgl. Figur 3e). Die Knotenlabelfunktion KFd des Knotens d bleibt unverändert, da kein neuer Pfad zu dem Knoten d durch Hinzunahme des Knotens e in den Teilgraph zu berücksichtigten ist.

In dem fünften Iterationsschritt wird der Knoten g ausgewählt, da dieser unter Einhaltung der Restriktion R kostengünstiger zu erreichen ist als der Knoten d.

Die Knotenlabelfunktion KFd des Knotens d in dem sechsten Iterationsschritt ist in Fig. 3f dargestellt. Der kostengünstigste Pfad in der Knotenlabelfunktion KFd des Knotens d wäre durch den Punkt (9, 19) repräsentiert. Da dieser jedoch, wie in Fig. 3f zu sehen ist, die Restriktion R mit dem Wert des Restriktionsparameters 17 überschreitet, darf dieser Pfad nicht gewählt werden.

Es muß ein kostenungünstigerer Pfad, der die Restriktion R einhält, gewählt werden.

Dies ist in diesem Beispielsfall der Pfad, der durch den Punkt (13, 14) repräsentiert wird. Auch wenn in diesem sehr einfachen Beispiel sich lediglich in dem letzten Verfahrensschritt ein Unterschied zu dem üblichen Shortest-Path-Verfahren zeigt, so ist jedoch bei einem komplexeren Verfahren aus diesem einfachen Beispiel schon sofort ersichtlich, daß durch die Verwendung einer mehrdimensionalen Knotenlabelfunktion im Vergleich zu einer der Verwendung eines Knotenlabels bei bekannten Verfahren die explizite Berücksichtigung von Restriktionen erstmals möglich wird.

Die durch diese Vorgehensweise sich ergebenden kostenoptimierten Kopplungen sind duch folgende Weiterbildungen noch verbesserbar.

Der nach dem Verfahren sich ergebende kostenoptimierte Graph, der die kostenoptimierten Kopplungen zwischen den einzelnen Knoten KNi aufweist, wird einem sog. Ripup/Reroute-Verfahren für mindestens einen Teil der Knoten des kostenoptimierten Graphen unterzogen. Eine Übersicht über bekannte Ripup/Reroute-Verfahren sind in dem Dokument [4] zu finden.

Ein Knoten, für den das Ripup/Reroute-Verfahren durchgeführt wird, wird im weiteren als Ripup-Knoten bezeichnet.

Ausgehend von einem frei wählbaren Ripup-Knoten wird in Richtung des Wurzelknotens b ein Pfad beispielsweise maximaler Länge gesucht, dessen innere Knoten beispielsweise vom Grad 2 sind. Dieser Pfad wird aus dem kostenoptimierten Graphen entfernt. Damit zerfällt der kostenoptimierte Graph in den durch die Entfernung des Pfades abgetrennten Unterbaum mit dem Ripup-Knoten w als Wurzelknoten und einen Restbaum mit dem ursprünglichen Wurzelknoten b.

Ausgehend von dem Ripup-Knoten w werden in einem sog. Reroute-Schritt Pfade ermittelt, die
- den bei dem Ripup-Knoten w wurzelnden Unterbaum mit dem Restbaum verbinden,
- geringere oder gleich Kosten aufweisen als der durch das Ripup/Reroute-Verfahren entfernte Pfad und,
- in einer Weiterbildung des Verfahrens vorteilhafterweise zu keiner Überschreitung der Restriktion R in irgendeinem Knoten des abgetrennten Baums führen.

Zur Berechnung der Pfade in dem Reroute-Schritt können die gleichen Verfahren zur Bestimmung kostengünstigster Pfade verwendet werden wie bei dem ursprünglichen Verfahren.

Beispielsweise der kostenkürzeste Pfad wird unter allen ermittelten Pfaden ausgewählt und in die Lösung eingesetzt, wodurch ein neuer kostenoptimierter Graph entsteht.

In einer Weiterbildung des Ripup/Reroute-Verfahren ist es vorgesehen, zur Ermittlung der Pfade in dem RerouteVerfahrensschritt lediglich eine Umgebung des Ripup-Knotens vorgebbarer Größe zu berücksichtigen. Durch diese Weiterbildung wird der benötigte Rechenbedarf zur Durchführung des Verfahrens erheblich verringert.

In Figur 4 ist das Verfahren in einem Ablaufdiagramm dargestellt.

In einem ersten Schritt 401 wird zur Ermittlung der optimierten Kopplungen des Graphen G ein Steiner-Baum-Problem gelöst. Dabei wird mindestens eine frei vorgebbare Restriktion berücksichtigt 402.

Das Verfahren, welches im vorigen allgemein anhand eines sehr einfachen Ausführungsbeispiels dargestellt wurde, kann in verschiedensten technischen Gebieten sehr vorteilhaft eingesetzt werden, beispielsweise bei der kostenoptimierten Planung und/oder Verlegung von Kommunikationsnetzen, die vorteilhafterweise eine Baumstruktur aufweisen.

In diesem technischen Gebiet gilt es, einen Graphen G, der eine Geländetopologie, beispielsweise in Form eines Stadtplanes, in digitalisierter Form mit Bedarfspunkten, die den Knoten KNi des Graphen G entsprechen, zu bearbeiten.

Der Wurzelknoten des Graphen G kann in diesem Zusammenhang z. B. ein Einspeisungspunkt von elektrischen Signalen zur Kommunikation in das zu errichtende Kommunikationsnetz aus einer übergeordneten Struktur sein.

Bei der Planung von Kommunikationsnetzen ist oftmals eine Längenrestriktion, beispielsweise eine maximale Entfernung der Bedarfspunkte von dem Einspeisungspunkt zu berücksichtigen.

Die Kosten sind für diesen Fall beispielsweise derart zu interpretieren, daß mit ihnen beispielsweise reale, längenabhängige Tiefbaukosten beschrieben werden und/oder fiktive Kosten zur Darstellung von Erschwernissen beim Aufbau des Kommunikationsnetzes, beispielsweise beim Überqueren von Straßen zum Bau von Gräben für Kabel für das Kommunikationsnetz.

Mit dem Graphen G werden mögliche Topologien für das spätere Kommunikationsnetz beschrieben. Durch das Verfahren wird es in diesem Anwendungsfall möglich, erhebliche Einsparungen bei Tiefbaukosten für die zu errichtenden Kommunikationsnetze für ein vorgebbares Gebiet zu erreichen.

So kann beispielsweise jeweils ein Graph G als ein sog. RDLU-Bereich (Regional Line Destibution Unit) interpretiert werden. Weist der Graph G eine hierarchische Baumstruktur auf, so bildet die RDLU beispielsweise den Wurzelknoten des Graphen G mit hierarchischer Baumstruktur. Mit der RDLU kann eine begrenzte Anzahl von Teilnehmern versorgt werden. Die Blätter des Baumes sind als sog. Endverzweiger (EVZ) interpretierbar, an die Teilnehmer des Kommunikationsnetzes angeschlossen werden können. In diesem technischen Gebiet sind beispielsweise folgende Restriktion zu beachten, die entsprechend dem oben dargestellten einfachen Ausführungsbeispiel in dem Verfahren berücksichtigt werden können.

Im sog. RDLU-Nahbereich, was einer Trassenlänge von 500 m entspricht, können EVZ direkt über mehrdratige Kupferkabel an die RDLU angeschlossen werden. Außerhalb dieses Bereiches werden EVZ an sog. Access-Multiplexer (AMX) angeschlossen. Die Kopplungen zwischen AMX und EVZ werden beispielsweise über Kupferkabel hergestellt, wobei die Entfernung zwischen AMX und EVZ aus Dämpfungsgründen 400 m nicht überschreiten sollte. Abhängig davon, welcher Art die von Bauelement des einzelnen Knoten interpretiert werden soll, ist die jeweilige Restriktion R zu wählen, beispielsweise die Länge von 500 m, um somit einen kostenoptimierten Pfad im RDLU-Nahbereich zu ermitteln.

Das Verfahren kann jedoch in völlig analoger Weise auch zum Layout-Design von Computerchips, beispielsweise dem VSLI-Design eingesetzt werden. Hierbei ist jedoch der Restriktionsparameter nicht in einer Längenangabe, sondern in einer Timing-Restriktion als einer Zeitangabe, die der Laufzeit von elektrischen Signalen entspricht, zu sehen. Diese Restriktion der Laufzeit von Signalen ist einzuhalten, da diese wesentlich ist für die Taktrate der entworfenen Schaltung.

In Figur 5 ist eine Rechneranordnung dargestellt, mit der das Verfahren durchgeführt werden kann. Die Rechneranordnung weist einen Rechner RE, zusätzlich z. B. eine Tastatur TA, eine Maus MA, und einen Bildschirm BS auf.

Im Rahmen dieses Dokuments wurden folgende Veröffentlichungen zitiert:
[1] B. Cherkassky, Shortest Part Algorithm, Theory and Experimental Evaluation, Stanford University Computer Science Department, S. 1-45, 3. August 1993
[2] T. Lengauer, Combinatorial Algorithms for Integrated Circuit Layout, John Wiley & Sons, ISBN 0-471-92838-0, S. 79 - 92, 1990
[3] F. Hwang et al, The Steiner Tree Problem, Elsevier Science Publishers, ISBN 0-444-89098, S. 93 - 102, 1992
[4] W. A. Dees, Jr. and G. Karger, Automated rip-up and reroute techniques, Proceedings of the 19th Design Automation Conference, ACM/IEEE, S. 432 - 439, 1982
[5] R. Tarjan, Data Structures and Network Algorithms, 5. Auflage, ISBN 0-89871-187-8, S. 85 - 96, 1983

## Patentansprüche

1. Verfahren zur rechnergestützten Ermittlung von optimierten Kopplungen von Knoten in einem vorgegebenen Graph möglicher Kopplungen, welcher eine beliebige Anzahl von Knoten und Kanten aufweist, wobei der Graph die Struktur eines technischen Systems beschreibt, durch einen Rechner,
- bei dem zur Ermittlung der optimierten Kopplungen ein Steiner-Baum-Problem gelöst wird, und
- bei dem bei der Lösung des Steiner-Baum-Problems mindestens eine frei vorgebbare Restriktion berücksichtigt wird,
- bei dem mindestens einem Teil der Knoten (KN) des Graphen eine Knotenlabelfunktion (KF) zugeordnet wird,
- bei dem mindestens einem Teil der Kanten (KA) des Graphen Kosten zugeordnet werden, und
- bei dem mit der Knotenlabelfunktion (KF) eine Funktion der Kosten, welche Funktion abhängig von der mindestens einen Restriktion ist, beschrieben wird.

2. Verfahren nach Anspruch 1,
bei dem mit der Knotenlabelfunktion (KF) eine Menge möglicher Pfade zwischen einem ersten Knoten und einem zweiten Knoten beschrieben wird.

3. Verfahren nach Anspruch 1 oder 2,
bei dem zur Lösung des Steiner-Baum-Problems ein Verfahren zur Ermittlung kürzester Pfade verwendet wird.

4. Verfahren nach einem der Ansprüche 1 bis 3,
bei dem für den Fall, daß zwischen zwei Knoten ein kostengünstigerer Pfad ermittelt wird, die Knotenlabelfunktionen (KF) mindestens zweier benachbarter Knoten miteinander kombiniert werden.

5. Verfahren nach Anspruch 4,
bei dem die Kombination der Knotenlabelfunktionen (KF) durch Bildung einer Optimal-Einhüllenden bezüglich der Kosten und der Restriktion der Knotenlabelfunktionen (KF) erfolgt.

6. Verfahren nach einem der Ansprüche 1 bis 5,
bei dem die mindestens eine Restriktion durch eine Längenrestriktion auf Pfaden und/oder durch eine zeitliche Restriktion von Pfaden gegeben ist.

7. Verfahren nach einem der Ansprüche 1 bis 6,
bei dem ein Punkt der Knotenlabelfunktion (KF), bei dem die mindestens eine Restriktion überschritten wird, im Verfahren nicht weiter berücksichtigt wird.

8. Verfahren nach einem der Ansprüche 1 bis 7,
bei dem für einen sich ergebenden optimierten Graphen für mindestens einen Teil des kostenoptimierten Graphen ein Ripup/Reroute-Verfahren durchgeführt wird.

9. Verfahren nach Anspruch 8,
bei dem das Ripup/Reroute-Verfahren für jeweils mindestens einen Ripup-Knoten mindestens folgende Verfahrensschritte umfaßt:
- ausgehend von dem Ripup-Knoten wird entlang des optimierten Graphen in Richtung eines Wurzelknotens des kostenoptimierten Graphen ein Ripup-Pfad ermittelt, der Knoten des Grades 2 enthält,
- der Ripup-Pfad wird aus dem optimierten Graphen entfernt,
- mindestens eine Reroute-Verbindung wird zwischen dem Ripup-Knoten und dem Restbaum ermittelt,
- bei dem Kosten, die durch eine Verbindung des Ripup-Knotens mit dem Restbaum verursacht werden, kleiner oder gleich den Kosten sind, die durch die aufgetrennte Verbindung verursacht wurden, und
- bei dem die Reroute-Verbindung in den optimierten Graphen aufgenommen wird.

10. Verfahren nach Anspruch 9,
bei dem die mindestens eine Restriktion bei der Ermittlung der Reroute-Verbindung berücksichtigt wird.

11. Verfahren nach Anspruch 9 oder 10,
bei dem die Reroute-Verbindung in einer lokalen Umgebung des vorgebbarer Größe Ripup-Knotens ermittelt wird.

12. Verfahren nach einem der Ansprüche 1 bis 11 eingesetzt zur Planung und/oder Verlegung von Kommunikationsnetzen,
- bei dem mit den Knoten des Graphen mindestens Bedarfsknoten und/oder Einspeiseknoten des Kommunikationsnetzes beschrieben werden, und
- bei dem mit den Kosten die Kosten zur Realisierung des Kommunikationsnetzes beschrieben werden.

13. Verfahren nach einem der Ansprüche 1 bis 11 eingesetzt zum Layout-Design in einem elektrischen Netzwerkgraphen,
- bei dem mit den Knoten des Graphen elektrische Komponenten des elektrischen Netzwerkgraphen beschrieben werden, und
- bei dem mit den Kosten die Kosten zur Realisierung des elektrischen Netzwerkgraphen beschrieben werden.

## Claims

1. Method for the computer-aided determination of optimized couplings of nodes in a prescribed graph of possible couplings which has an arbitrary number of nodes and edges, the graph describing the structure of a technical system, by means of a computer,
- in which a Steiner tree problem is solved to determine the optimized couplings and,
- in which at least one freely prescribable constraint is taken into account in solving the Steiner tree problem,
- in which at least one portion of the nodes (KN) of the graph is assigned a node label function (KF),
- in which at least one portion of the edges (KA) of the graph is assigned costs, and
- in which the node label function (KF) is used to describe a function of the costs, which function depends on the at least one constraint.

2. Method according to Claim 1, in which the node label function (KF) is used to describe a set of possible paths between a first node and a second node.

3. Method according to Claim 1 or 2, in which a method for determining the shortest paths is used to solve the Steiner tree problem.

4. Method according to one of Claims 1 to 3, in which the node label functions (KF) of at least two adjacent nodes are combined with one another for the case in which a more cost-effective path is determined between two nodes.

5. Method according to Claim 4, in which the combination of the node label functions (KF) is performed by forming an optimum envelope with reference to the costs and the constraint of the node label functions (KF) .

6. Method according to one of Claims 1 to 5, in which the at least one constraint is given by a length constraint on paths and/or by a time constraint on paths.

7. Method according to one of Claims 1 to 6, in which a point of the node label function (KF) at which the at least one constraint is exceeded is not further taken into account in the method.

8. Method according to one of Claims 1 to 7, in which a rip-up/reroute method is carried out for a resulting optimized graph for at least one portion of the cost-optimized graph.

9. Method according to Claim 8, in which the rip-up/reroute method for respectively at least one rip-up node comprises at least the following method steps:
- starting from the rip-up node, a rip-up path which includes nodes of degree 2 is determined along the optimized graph in the direction of a root node of the cost-optimized graph,
- the rip-up path is removed from the optimized graph,
- at least one reroute connection is determined between the rip-up node and the residual tree,
- in which costs which are caused by a connection of the rip-up node to the residual tree are less than or equal to the costs which were caused by the separated connection, and
- in which the reroute connection is incorporated into the optimized graph.

10. Method according to Claim 9, in which the at least one constraint is taken into account in determining the reroute connection.

11. Method according to Claim 9 or 10, in which the reroute connection is determined in a local environment of the prescribable variable of rip-up node.

12. Method according to one of Claims 1 to 11 used for planning and/or laying communications networks,
- in which at least demand nodes and/or feed nodes of the communications network are described by the nodes of the graph, and
- in which the costs of realizing the communications network are described by the costs.

13. Method according to one of Claims 1 to 11 used for layout design in an electric network graph,
- in which electric components of the electric network graph are described by the nodes of the graph, and
- in which the costs of realizing the electric network graph are described by the costs.

## Revendications

1. Procédé de détermination assisté par ordinateur de couplages optimum de points nodaux dans un graphe prescrit de couplages possibles, ledit graphe comportant un nombre quelconque de points nodaux et de côtés, le graphe décrivant la structure d'un système technique, par un ordinateur
- dans lequel on résout un problème d'arbre de Steiner pour déterminer les couplages optimum, et
- dans lequel on prend en compte pour la solution du problème d'arbre de Steiner au moins une restriction pouvant être librement prescrite,
- dans lequel on associe une fonction (KF) d'indication de points nodaux à au moins une partie des points (KN) nodaux du graphe,
- dans lequel on associe des coûts à au moins une partie des côtés (K) du graphe, et
- dans lequel on décrit par la fonction (KF) d'indication de points nodaux une fonction des coûts qui est une fonction dépendant de la au moins une restriction.

2. Procédé suivant la revendication 1, dans lequel on décrit par la fonction (KF) d'indication de points nodaux une quantité de chemins possibles entre un premier point nodal et un deuxième point nodal.

3. Procédé suivant la revendication 1 ou 2, dans lequel on utilise pour résoudre le problème d'arbre de Steiner un procédé de détermination de chemins les plus courts.

4. Procédé suivant l'une des revendications 1 à 3, dans lequel on combine entre elles les fonctions (KF) d'indication de points nodaux d'au moins deux points nodaux voisins pour le cas où un chemin moins onéreux est déterminé entre deux points nodaux.

5. Procédé suivant la revendication 4, dans lequel on effectue la combinaison des fonctions (KF) d'indication de points nodaux par formation d'une enveloppe optimale relativement aux coûts et à la restriction des fonctions (KF) d'indication de points nodaux.

6. Procédé suivant l'une des revendications 1 à 5, dans lequel la au moins une restriction est donnée par une restriction de longueur sur des chemins et/ou par une restriction de chemins dans le temps.

7. Procédé suivant l'une des revendications 1 à 6, dans lequel on ne tient plus compte dans le procédé d'un point de la fonction (KF) d'indication de points nodaux pour lequel la au moins une restriction est dépassée.

8. Procédé suivant l'une des revendications 1 à 7, dans lequel on effectue un procédé ripup/reroute pour un graphe optimisé résultant, pour au moins une partie du graphe optimisé du point de vue des coûts.

9. Procédé suivant la revendication 8, dans lequel le procédé ripup/reroute comprend pour chaque au moins un point nodal ripup au moins les étapes de procédé suivantes :
- à partir du point nodal ripup, on détermine le long du graphe optimisé, en direction d'un point nodal racine du graphe optimisé du point de vue des coûts, un chemin ripup qui contient des points nodaux du degré 2,
- on retire le chemin ripup du graphe optimisé,
- on détermine au moins une liaison reroute entre le point nodal ripup et l'arbre restant,
- dans lequel des coûts qui ont été causés par une liaison du point nodal ripup avec l'arbre restant sont inférieurs ou égaux aux coûts qui ont été provoqués par la liaison détachée, et
- dans lequel la liaison reroute est reçue dans le graphe optimisé.

10. Procédé selon la revendication 9, dans lequel on tient compte de la au moins une restriction pour la détermination de la liaison reroute.

11. Procédé suivant la revendication 9 ou 10, dans lequel on détermine la liaison reroute dans un voisinage local du point nodal de ripup de dimensions pouvant être prescrites.

12. Procédé suivant l'une des revendications 1 à 11, utilisé pour concevoir et/ou poser des réseaux de communication,
- dans lequel on décrit par les points nodaux du graphe au moins des points nodaux auxiliaires et/ou des points nodaux d'alimentation du réseau de communication, et
- dans lequel on décrit par les coûts les coûts de réalisation du réseau de communication.

13. Procédé suivant l'une des revendications 1 à 11, utilisé pour le dessin d'ébauche dans un graphe de réseau électrique
- dans lequel on décrit par les points nodaux du graphe des composants électriques du graphe de réseau électrique, et
- dans lequel on décrit par les coûts les coûts de réalisation du graphe de réseau électrique.
